# FASCICULE DE BREVET EUROPEEN

(11) **EP 3 535 695 B1**
(45) Date de publication et mention de la délivrance du brevet: **27.05.2020**
(21) Numéro de dépôt: 17808531.2
(22) Date de dépôt: 02.11.2017
(51) Int. Cl.: G06K 19/077

(54) **PROCÉDÉ DE FABRICATION D'UN MODULE ÉLECTRONIQUE POUR CARTE À PUCE**
VERFAHREN ZUR HERSTELLUNG EINES ELEKTRONISCHEN MODULS FÜR EINE CHIPKARTE
METHOD FOR MANUFACTURING AN ELECTRONIC MODULE FOR A SMART CARD

(30) Priorité: 04.11.2016 FR 1601576
(43) Date de publication de la demande: 11.09.2019
(73) Titulaire: Smart Packaging Solutions (S.P.S), 13790 Rousset (FR)
(72) Inventeur: LEIVA, Katia, 13790 Rousset (FR); LIVRATI, Didier, 13790 Rousset (FR); CALVAS, Bernard, 13790 Rousset (FR)
(74) Mandataire: Nicolle, Olivier
(86) Numéro de dépôt international: PCT/FR2017/000206
(87) Numéro de publication internationale: WO 2018/083389

(56) Documents cités:
- EP-A1- 2 605 188
- EP-A1- 2 608 114
- FR-A1- 2 996 944
- US-A1- 2008 205 012

## Description

L'invention concerne un procédé de fabrication d'un module électronique à contact, ou à double interface de communication à contact et sans contact, et une carte à puce intégrant un tel module.

### Etat de la technique

Il existe déjà dans l'état de la technique un grand nombre de modules microélectroniques pour cartes à puce à fonctionnement à contact, à fonctionnement sans contact, ou à fonctionnement mixte à contact et sans contact.

La plupart des cartes à double interface de communication conformes à l'état de la technique sont constituées :
- d'un module électronique comportant une puce microélectronique, un bornier de connexion à contact destiné à être mis en contact avec les bornes correspondantes d'un lecteur de carte à puce à contact, et deux contacts situés en face arrière permettant la connexion à l'antenne;
- d'une carte en matière plastique, comportant une antenne;
- d'un matériau électriquement conducteur permettant la connexion entre le module électronique et l'antenne.

Pour réaliser un tel module, il est nécessaire de déposer la puce sur un substrat, puis de réaliser les connexions électriques entre les bornes correspondantes de la puce et de l'interface de communication du module, typiquement à l'aide de fils de connexion très fins.

Ensuite il est nécessaire de protéger les contacts de la puce, et les fils de connexion, avec une goutte de résine d'enrobage polymérisable. Puis on insole la goutte de résine pour la polymériser. Il est alors nécessaire d'attendre environ un jour pour que la résine termine sa réticulation, puis on procède à un traitement thermique, qui dure plusieurs heures.

Enfin on dépose un adhésif sur une face du module et on colle le module dans la cavité de la carte.

Lorsque la goutte de résine d'enrobage est durcie, elle présente encore une forme bombée. Le module doit alors être rectifié pour le ramener à l'épaisseur désirée.

On constate que l'ensemble de ces opérations est complexe et prend du temps, pour un total pouvant aller jusqu'à 5 jours.

On connaît en particulier de par le document US 2008/205012 A1 un procédé de fabrication d'un module électronique pour carte à puce comportant un substrat pourvu d'une cavité dans laquelle est fixée une puce microélectronique dont les bornes de sortie sont connectées à des contacts de la carte à puce par des fils de connexion métalliques constituant des boucles en relief par rapport à la face du substrat.

### Buts de l'invention

Un but général de l'invention est par conséquent de proposer un procédé de fabrication d'un module électronique pour carte à puce à contact ou pour carte à puce à double interface de communication à contact et sans contact, qui soit dépourvu des inconvénients précités.

Un autre but de l'invention est de proposer un procédé de fabrication d'un module électronique permettant de réduire sensiblement le nombre d'étapes de fabrication, ainsi que les coûts et durées associés, mais sans nuire au niveau de fiabilité habituellement obtenu avec les procédés connus.

### Résumé de l'invention

Le principe de l'invention consiste, après la phase de connexion des plots électriques à l'aide de fils de connexion, à coucher les boucles en surépaisseur réalisées par les fils, à l'aide d'une couche de matière, suffisamment rigide pour abaisser les boucles et réduire l'épaisseur du produit, mais suffisamment souple pour que les fils de connexion s'y incrustent sans générer de surépaisseur.

L'invention a par conséquent pour objet un procédé de fabrication d'un module électronique pour carte à puce, ledit module comportant un substrat dont au moins une face comporte une couche métallique, ledit substrat étant pourvu d'une cavité dans laquelle est fixée une puce microélectronique pourvue de bornes de sortie pour la connexion à un bornier de contacts électriques ou à une antenne de la carte à puce, ladite connexion étant réalisée par des fils de connexion métalliques constituant des boucles en relief par rapport à une face du substrat, caractérisé en ce qu'il comporte une étape, après le câblage des fils de connexion, consistant à recouvrir la face du module comportant la cavité, à l'aide d'un couvercle qui vient coucher les boucles des fils en relief pour en réduire la hauteur et les plaquer vers ladite face du substrat.

Le procédé selon l'invention s'applique aussi bien à la fabrication de modules pourvus de deux couches métalliques situées de part et d'autre du substrat, ou d'une seule couche métallique située sur une seule face du substrat.

Ainsi, lorsque le module électronique comporte une couche métallique supérieure et une couche métallique inférieure situées de part et d'autre du substrat, les fils de connexion formant des boucles en relief par rapport à la couche métallique supérieure, le procédé prévoit que le couvercle vient plaquer les fils sur ladite couche métallique supérieure.

Mais lorsque le module électronique comporte uniquement une couche métallique inférieure, les fils de connexion formant des boucles en relief par rapport au substrat, le procédé prévoit que le couvercle vient plaquer les fils directement sur ledit substrat.

Selon un aspect de l'invention, ledit couvercle est réalisé en une matière plastique malléable, suffisamment rigide pour remplir son rôle de couvercle, et suffisamment souple pour permettre une certaine incrustation des fils dans l'épaisseur du couvercle, ce qui contribue à les maintenir en place.

L'invention a également pour objet un module électronique obtenu par le procédé ci-dessus, et une carte à puce comprenant un tel module électronique perfectionné et simplifié.

D'autres caractéristiques et avantages de l'invention apparaîtront à la lecture de la description détaillée et des dessins annexés dans lesquels :
- la figure 1 illustre un module électronique pour carte à puce, en vue de dessus;
- la figure 2 est une vue en coupe du module électronique de la figure 1, montrant une goutte de résine rectifiée conformément au procédé de fabrication connu;
- la figure 3 est une vue en coupe du module électronique de la figure 1, avant couchage des fils de connexion ;
- la figure 4 est une vue en coupe du module électronique de la figure 3 après couchage des fils de connexion selon le procédé de l'invention;
- les figures 5A, 5B et 5C représentent en vue en coupe agrandie trois modes d'incrustation des fils de connexion dans la couche de fermeture du module;
- la figure 6 est une vue en coupe montrant l'application du procédé selon l'invention à une variante d'un module correspondant à un module à contact, sans antenne.

### Description détaillée

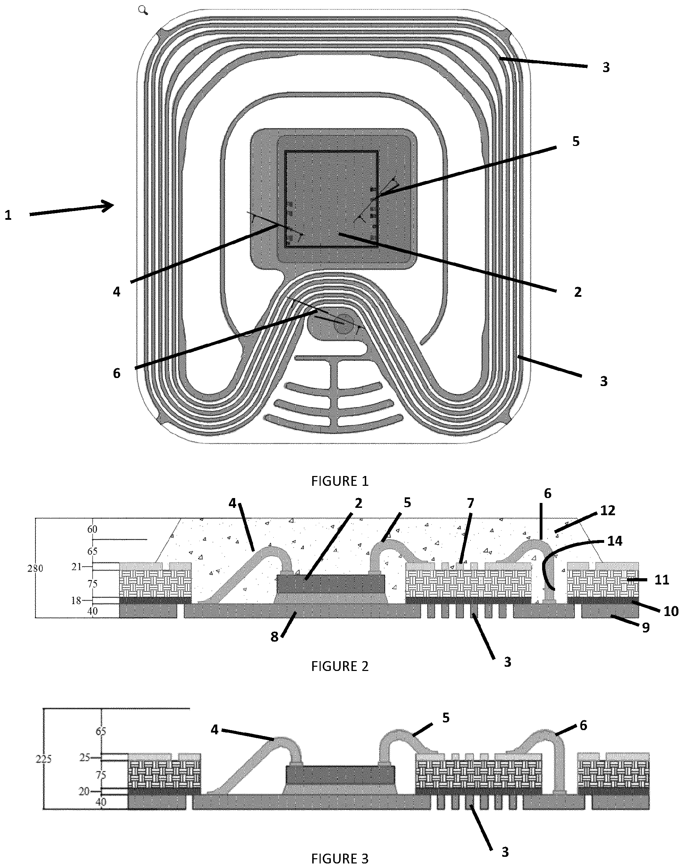

En figure 1 on a représenté un vue de dessus un module microélectronique 1 pour carte à puce sans contact. Ce module 1 comporte de façon classique une cavité au fond de laquelle se trouve une plage de réception d'une puce microélectronique 2, les spires d'une antenne 3, des fils de connexion 4,5,6 entre les plots de l'interface de communication de la puce, et des plots correspondants de l'antenne 3.

La vue en coupe de la figure 2 est réalisée le long des fils de connexion 4,5,6 de la figure 1. Elle montre plus en détail la structure du module, qui a été obtenu avec un procédé de fabrication classique. Ainsi, la puce 2 est collée sur une couche métallique 8 qui comprend également des spires de l'antenne 3.

Dans l'exemple représenté aux figures 2 à 4, le module comporte deux couches métalliques 7,8, situées de part et d'autre d'un substrat isolant 11, et un adhésif 10. Les bornes de l'interface de communication de la puce 2 (non représentées) sont connectées par les fils 4,5,6 aux contacts métalliques du module, et/ou à des bornes de l'antenne 3. Le fil de connexion 6 relie une plage métallique de la couche métallique supérieure 7, à une plage de connexion de la couche métallique inférieure 8. A cet effet, il passe dans un puits 14.

Cette structure à deux couches métalliques 7,8 est typique d'un module pour carte à puce à double interface de communication à contact et sans contact.

Comme on le voit, les fils de connexion 4,5,6 forment des boucles qui sont en relief par rapport à la couche métallique supérieure 7. Cette surépaisseur est absorbée, dans l'état de la technique, par une résine d'encapsulation 12, qui protège par conséquent les fils 4,5,6. Comme on le voit sur la figure 2, la résine d'encapsulation présente une surface plane, il s'agit d'une goutte de résine représentée dans son état après usinage, le module étant alors prêt pour être reporté dans une cavité appropriée d'un produit fini tel qu'une carte à puce, ou dans un insert pour produit sans contact tel que des passeports électroniques ou autres documents officiels.

Comme on le voit, les côtes d'épaisseur indiquées du côté gauche de la figure 2, montrent une épaisseur globale du module de 280 micromètres. Un des objectifs du procédé selon l'invention est, en plus de la simplification des étapes de fabrication, de permettre une réduction de cette épaisseur, sans réduire l'épaisseur de la puce ou des autres composants.

La figure 3 montre une vue en coupe similaire à celle de la figure 2. Il s'agit d'un module câblé avec les fils métalliques 4,5,6 qui forment des boucles en relief par rapport à la face supérieure du substrat qui porte la couche métallique supérieure 7, mais avant toute opération d'enrobage de la puce.

A ce stade du procédé de fabrication, l'invention prévoit, à la place d'une goutte de résine d'enrobage, de protéger la puce à l'aide d'un couvercle 13 appliqué directement sur la face supérieure du module située du côté de la cavité, de manière à recouvrir la puce, la cavité, et la plaque métallique supérieure 7. Le couvercle 13 est appliqué de manière à coucher les fils de connexion 4,5,6 et à les plaquer en direction du substrat pour les ramener à la hauteur de la surface supérieure de la couche métallique 7. On a en effet constaté de façon surprenante que les fils pouvaient être ainsi plaqués sans causer de rupture de leurs connexions aux plages métalliques et sans nuire à la fiabilité du module.

Comme on le voit, l'épaisseur du module est ramenée, grâce à l'invention, à 180 micromètres, soit un tiers de moins que dans la figure 2.

De façon avantageuse, on choisit pour le couvercle 13 une matière thermoplastique tel qu'un polyuréthane, suffisamment rigide pour remplir son rôle de couvercle, et suffisamment souple pour permettre une certaine incrustation des fils 4,5,6 dans l'épaisseur du couvercle 13, ce qui contribue à les maintenir en place.

Un adhésif peut encore être disposé des 2 côtés du module pour faciliter son report dans un produit fini tel qu'une carte à puce.

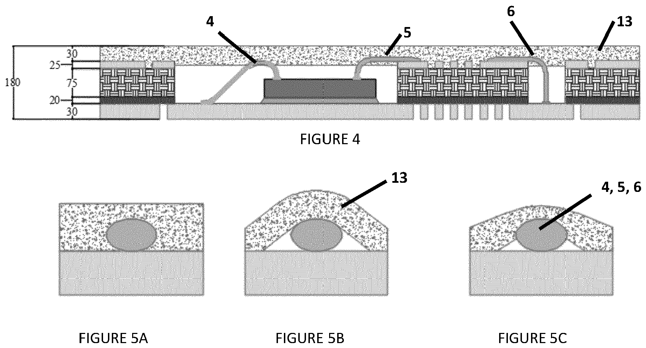

Les figures 5A, 5B et 5C montrent un léger écrasement des fils, et une incrustation plus ou moins prononcée des fils dans le couvercle 13, dont la déformation est représentée de façon exagérée.

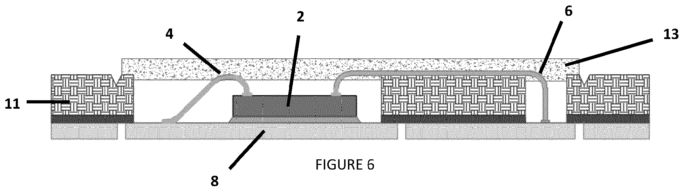

Dans la figure 6 on a représenté en coupe un module pourvu d'un couvercle 13 comme précédemment, mais il s'agit d'un module dit simple face, à contacts et compatible avec la norme 7816-1. Il ne comporte qu'une seule couche métallique 8, opposée à la face du substrat qui reçoit le couvercle 13.

Dans ce cas, le couvercle 13 peut plaquer les boucles des fils 4,5,6 directement sur le substrat 11.

L'unique couche métallique 8 sert dans ce cas de figure à réaliser les contacts du bornier dans le cas d'une carte à fonctionnement à contact, ou les pistes d'une antenne. Une structure analogue peut être réalisée avec un module à double interface de communication.

### Avantages de l'invention

En définitive, l'invention propose un nouveau procédé de fabrication amélioré pour obtenir un module pour carte à puce, répondant aux buts fixés.

Grâce à ce procédé, il n'est plus nécessaire d'encapsuler la puce avec une résine, et toutes les opérations requises pour le traitement de l'encapsulation, telles que la cuisson de la résine et la rectification d'épaisseur, deviennent inutiles.

Il en résulte un gain de temps d'environ 2 jours par rapport au temps de cycle de fabrication qui était précédemment de l'ordre de 5 jours.

La simplicité des opérations requises pour la fabrication du module avec la pose du couvercle entraine également une diminution des coûts de fabrication.

Accessoirement, ce procédé permet d'obtenir des modules d'une épaisseur encore réduite, de l'ordre de 180 micromètres (à paramètres constants concernant l'épaisseur du substrat, de la puce, et des fils), ce qui permet encore d'augmenter les cas d'usages possibles d'un tel module et des cartes à puce ou documents qui l'incorporent.

Le nouveau procédé est applicable quel que soit le type de carte à puce: à contact, sans contact, duale.

Enfin, le choix adéquat de la couleur de la couche supérieure permet une intégration optimale dans le produit fini.

## Revendications

1. Procédé de fabrication d'un module électronique pour carte à puce, ledit module comportant un substrat (11) dont au moins une face comporte une couche métallique (7,8), ledit substrat (11) étant pourvu d'une cavité dans laquelle est fixée une puce microélectronique (2) pourvue de bornes de sortie pour la connexion à un bornier de contacts électriques ou à une antenne de la carte à puce, ladite connexion étant réalisée par des fils de connexion métalliques (4,5,6) constituant des boucles en relief par rapport à une face du substrat, **caractérisé en ce qu'**il comporte une étape, après le câblage des fils de connexion (4,5,6), consistant à recouvrir la face du module comportant la cavité, à l'aide d'un couvercle (13) qui vient coucher les boucles des fils (4,5,6) en relief pour en réduire la hauteur et les plaquer vers ladite face du substrat.

2. Procédé selon la revendication 1, dans lequel le module électronique comporte une couche métallique supérieure (7) et une couche métallique inférieure (8) situées de part et d'autre du substrat (11), les fils de connexion (4,5,6) formant des boucles en relief par rapport à la couche métallique supérieure (7), **caractérisé en ce que** le couvercle (13) vient plaquer les fils (4,5,6) sur ladite couche métallique supérieure (7).

3. Procédé selon la revendication 1, dans lequel le module électronique comporte uniquement une couche métallique inférieure (8), les fils de connexion (4,5,6) formant des boucles en relief par rapport au substrat (11), **caractérisé en ce que** le couvercle (13) vient plaquer les fils (4,5,6) sur ledit substrat (11).

4. Procédé selon l'une quelconque des revendications précédentes , **caractérisé en ce que** ledit couvercle (13) est réalisé en une matière plastique malléable, suffisamment rigide pour remplir son rôle de couvercle, et suffisamment souple pour permettre une certaine incrustation des fils (4,5,6) dans l'épaisseur du couvercle (13), ce qui contribue à les maintenir en place.

5. Procédé selon la revendication 4, **caractérisé en ce que** ladite matière plastique malléable est du polyuréthane.

6. Module électronique, **caractérisé en ce qu'**il est obtenu par le procédé selon l'une quelconque des revendications précédentes.

7. Carte à puce à double interface de communication à contact et sans contact, **caractérisé en ce qu'**elle comporte un module électronique selon la revendication 6.

## Patentansprüche

1. Verfahren zur Herstellung eines elektronischen Moduls für eine Chipkarte, wobei das Modul ein Substrat (11) aufweist, von dem mindestens eine Seite eine metallische Schicht (7, 8) aufweist, wobei das Substrat (11) mit einem Hohlraum versehen ist, in dem ein mikroelektronischer Chip (2) befestigt ist, der mit Ausgangsklemmen für die Verbindung mit einer Klemmenleiste elektrischer Kontakte oder mit einer Antenne der Chipkarte versehen ist, wobei die Verbindung durch metallische Verbindungsdrähte (4, 5, 6) durchgeführt wird, die bezüglich einer Seite des Substrats reliefartige Schleifen bilden, **dadurch gekennzeichnet, dass** es einen Schritt nach der Verkabelung der Verbindungsdrähte (4, 5, 6) aufweist, der darin besteht, die den Hohlraum aufweisende Seite des Moduls mit Hilfe eines Deckels (13) zu bedecken, der die reliefartigen Schleifen der Drähte (4, 5, 6) niederlegt, um ihre Höhe zu verringern und sie zu der Seite des Substrats anzudrücken.

2. Verfahren nach Anspruch 1, wobei das elektronische Modul eine obere metallische Schicht (7) und eine untere metallische Schicht (8) aufweist, die sich zu beiden Seiten des Substrats (11) befinden, wobei die Verbindungsdrähte (4, 5, 6) bezüglich der oberen metallischen Schicht (7) reliefartige Schleifen formen, **dadurch gekennzeichnet, dass** der Deckel (13) die Drähte (4, 5, 6) auf die obere metallische Schicht (7) andrückt.

3. Verfahren nach Anspruch 1, wobei das elektronische Modul nur eine untere metallische Schicht (8) aufweist, wobei die Verbindungsdrähte (4, 5, 6) bezüglich des Substrats (11) reliefartige Schleifen formen, **dadurch gekennzeichnet, dass** der Deckel (13) die Drähte (4, 5, 6) auf das Substrat (11) andrückt.

4. Verfahren nach einem der vorhergehenden Ansprüche, **dadurch gekennzeichnet, dass** der Deckel (13) aus einem formbaren Kunststoff hergestellt wird, der steif genug ist, um seine Aufgabe als Deckel zu erfüllen, und weich genug ist, um ein gewisses Einbetten der Drähte (4, 5, 6) in die Dicke des Deckels (13) zu erlauben, was dazu beiträgt, sie an Ort und Stelle zu halten.

5. Verfahren nach Anspruch 4, **dadurch gekennzeichnet, dass** der formbare Kunststoff Polyurethan ist.

6. Elektronische Modul, **dadurch gekennzeichnet, dass** es durch das Verfahren nach einem der vorhergehenden Ansprüche erhalten wird.

7. Chipkarte mit doppelter Kommunikationsschnittstelle mit Kontakt und ohne Kontakt, **dadurch gekennzeichnet, dass** sie ein elektronisches Modul nach Anspruch 6 aufweist.

## Claims

1. Manufacturing method for an electronic module for a smart card, said module having a substrate (11), at least one face of which has a metal layer (7, 8), said substrate (11) having a cavity in which a microelectronic chip (2) with output terminals for connection to an electrical contact terminal or to an antenna of the smart card is attached, said connection being made by metal connection wires (4, 5, 6) forming loops projecting from one face of the substrate, **characterized in that** it includes a step, after wiring the connection wires (4, 5, 6), that consists in covering the face of the module including the cavity with a cover (13) that flattens the loops of the projecting wires (4, 5, 6) in order to reduce the height thereof and push same towards said face of the substrate.

2. Method according to Claim 1, wherein the electronic module has an upper metal layer (7) and a lower metal layer (8) that are positioned on either side of the substrate (11), the connection wires (4, 5, 6) forming loops projecting from the upper metal layer (7), **characterized in that** the cover (13) presses the wires (4, 5, 6) against said upper metal layer (7).

3. Method according to Claim 1, wherein the electronic module has only a lower metal layer (8), the connection wires (4, 5, 6) forming loops projecting from the substrate (11), **characterized in that** the cover (13) presses the wires (4, 5, 6) against said substrate (11).

4. Method according to any one of the preceding claims, **characterized in that** said cover (13) is made of a malleable plastic material that is rigid enough to act as a cover and soft enough to allow a degree of embedding of the wires (4, 5, 6) in the thickness of the cover (13), which helps to keep said wires in place.

5. Method according to Claim 4, **characterized in that** said malleable plastic material is polyurethane.

6. Electronic module, **characterized in that** it is obtained using the method according to any one of the preceding claims.

7. Smart card with a dual contact/contactless communication interface, **characterized in that** it includes an electronic module according to Claim 6.
